# EUROPEAN PATENT SPECIFICATION

(11) **EP 1 696 495 B1**
(45) Date of publication and mention of the grant of the patent: **15.10.2014**
(21) Application number: 05004191.2
(22) Date of filing: 25.02.2005
(51) Int. Cl.: H01L 33/60, H01L 33/64

(54) **Light source apparatus and fabrication method thereof**
Lichtquellenvorrichtung und ihr Herstellungsverfahren
Appareil à source de lumière et son procédé de manufacture

(43) Date of publication of application: 30.08.2006
(73) Proprietor: LG Electronics Inc., Yongdungpo-Gu Seoul (KR)
(72) Inventor: Kim, Geun-Ho, Gangnam-Gu Seoul (KR); Song, Ki-Chang, Gyeonggi-do 437-768 (KR)
(74) Representative: Rupprecht, Kay

(56) References cited:
- US-A- 4 797 715
- US-A- 5 003 357
- US-A1- 2004 184 270
- US-A1- 2005 127 485
- PATENT ABSTRACTS OF JAPAN vol. 008, no. 111 (E-246), 24 May 1984 (1984-05-24) -& JP 59 027568 A (MITSUBISHI DENKI KK), 14 February 1984 (1984-02-14)
- PATENT ABSTRACTS OF JAPAN vol. 006, no. 218 (E-139), 2 November 1982 (1982-11-02) -& JP 57 120386 A (TATEISHI DENKI KK), 27 July 1982 (1982-07-27)
- PATENT ABSTRACTS OF JAPAN vol. 011, no. 195 (E-518), 23 June 1987 (1987-06-23) & JP 62 023163 A (MATSUSHITA ELECTRIC IND CO LTD), 31 January 1987 (1987-01-31)

## Description

### BACKGROUND OF THE INVENTION

### 1. Field of the Invention

The present invention relates to a light source apparatus and a fabrication method thereof, and more particularly, to a light source apparatus according to the preamble of claim 1 and a fabrication method thereof according to the preamble of claim 12 enabling light emitted from respective light emitting devices to be collected toward the front of a metal stem without loss of light.

Such an apparatus and method are known from US-A-4 797 715. From JP-A-57 120 386 a further method for bonding a light emitting device to a substrate is known.

### 2. Description of the Background Art

A light emitting device which is actively being used at the moment is typically divided into a laser diode (LD) and a light emitting diode (LED).

The LD is widely used as a light source in the field of optical communication, and has lately been used as an important component in the field of optical media such as a DVD player, a laser disc (LD) player, a mini disc (MD) player, or the like as well as in the filed of a compact disc (CD) player and a compact disc rewritable (CD-RW) player.

In addition, the LED is widely used in a backlight unit (BLU), and is used as a light source apparatus which is located at a lower portion of an LC PANEL which cannot emit by itself and makes an LCD recognized by irradiating uniform plane light.

Advantageously, the LED can be operated at a relatively low voltage, generates less heat because of high energy efficiency and has a long life span.

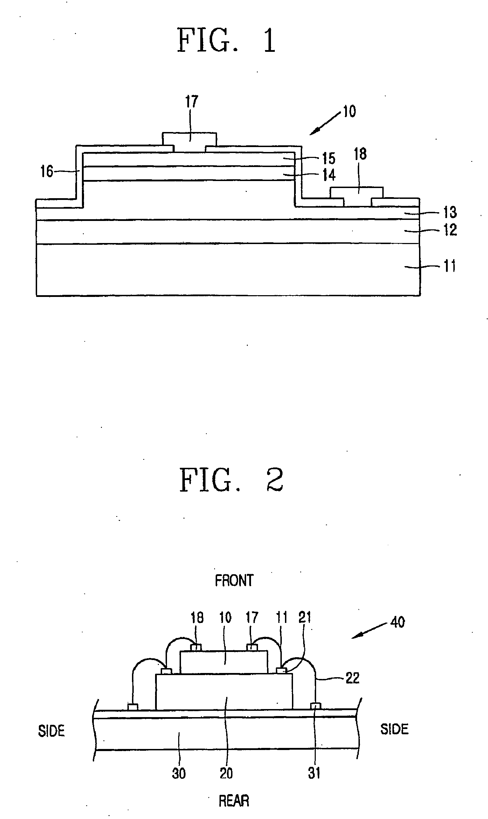

Figure 1 is a longitudinal sectional view showing the conventional light emitting device, and Figure 2 is a longitudinal sectional view showing the conventional light source apparatus.

As shown in Figure 1, the conventional light emitting device 10 is constructed in such a manner that a buffer layer 12, an n-contact layer 13, an active layer 14 and a p-contact layer 15 are sequentially deposited over a sapphire, n-GaAs or other substrate 11 by a chemical vapor deposition (CVD) method.

A current spraying layer 16 is formed on an upper surface of the p-contact layer 15. A p-electrode 17 which is electrically connected to the p-contact layer 15 and the current spraying layer 16 is formed on an upper surface of the current spraying layer 16. Next, an n-electrode 18 is formed on an upper surface of an exposed portion of the n-contact layer 13.

As shown in Figure 2, in the conventional light source apparatus 40, the light emitting device 10 is bonded to a sub-mount 20 by a normal mounting bonding method, and the sub-mount 20 is bonded to a metal stem 30. At this time, the p-electrode 17 of the light emitting device 10 is connected to an electrode 21 of the sub-mount 20 by a wire 11 in order to apply the external power, and the electrode 21 of the sub-mount 20 is connected to an electrode 31 of the metal stem 30 by another wire 22. Since the n-electrode 18 has the same connection structure as the p-electrode, reference numerals concerning the connection structure of the n-electrode 18 and a description therefor will be omitted hereinafter.

An operation of the conventional light source apparatus having such a construction will be described as follows.

As shown in Figures 1 and 2, when a voltage is applied to the electrode 31 of the metal stem 30, the voltage is applied to the p-electrode 17 and the n-electrode 18 through wires 11 and 22.

At this time, holes and electrons are injected into the p-electrode 17 and the n-electrode 18, respectively. The injected holes and electrons are introduced into the p-contact layer 15 and the n-contact layer 13 and then are recombined in the active layer 14. At this time, extra energy is changed into light, which is emitted.

However, in case of the conventional light source apparatus, light interference between the light emitting devices adjacent to each other occurs, and light emitted from the side of the light emitting device is not collected toward the front of the metal stem but disperses, thereby decreasing the luminous efficiency.

In addition, as for a connection between the light emitting device and the sub-mount and a connection between the sub-mount and the metal stem, a connection job is very difficult because the normal mounting bonding method using wires is used and thus yield is decreased.

### SUMMARY OF THE INVENTION

Therefore, an object of the present invention is to provide a light source apparatus and a fabrication method thereof capable of preventing light interference between light emitting devices adjacent to each other and increasing the luminous efficiency by collecting light emitted from the side of the light emitting device toward the front of the metal stem.

To achieve these and other advantages and in accordance with the purpose of the present invention, as embodied and broadly described herein, there is provided a light source apparatus as defined in claim 1.

An electrode of the light emitting device is directly connected with the electrode layer of the sub-mount, and the electrode layer of the sub-mount is connected with the electrode layer of the metal stem by a wire.

Preferably, the depth of the groove is formed to be relatively greater than the height of the light emitting device.

The metal stem is an MC PCB, and the light emitting device is an LED.

To achieve these and other advantages and in accordance with the purpose of the present invention, as embodied and broadly described herein, there is provided a fabrication method of a light source apparatus as defined in claim 11.

Preferably, a reflective layer and an insulating layer are sequentially formed on a front surface of the silicon substrate after the step of forming grooves on a front surface of the silicon substrate.

Preferably, a flip chip bonding method is used in the step of bonding the light emitting device to the solder layer of the sub-mount.

Preferably, the electrode layer of the sub-mount is connected with an electrode of the metal stem by a normal mounting method.

The foregoing and other objects, features, aspects and advantages of the present invention will become more apparent from the following detailed description of the present invention when taken in conjunction with the accompanying drawings.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

In the drawings:
Figure 1 is a longitudinal sectional view showing the conventional light emitting device;
Figure 2 is a longitudinal sectional view showing the conventional light source apparatus;
Figure 3 is a longitudinal sectional view showing a light source apparatus in accordance with the present invention;
Figure 4 is an exploded perspective view showing a sub-mount and a light emitting device in the light source apparatus in accordance with the present invention;
Figure 5 is a longitudinal sectional view showing the sub-mount and the light emitting device in the light source apparatus in accordance with the present invention; and
Figures 6 to 14 are flowcharts illustrating a fabrication method of the light source apparatus in accordance with the present invention.

### DETAILED DESCRIPTION OF THE PREFERRED EMBODIMENTS

Reference will now be made in detail to the preferred embodiments of the present invention, examples of which are illustrated in the accompanying drawings.

Hereinafter, a light source apparatus and a fabrication method thereof in accordance with the present invention will be described with reference to the accompanying drawings.

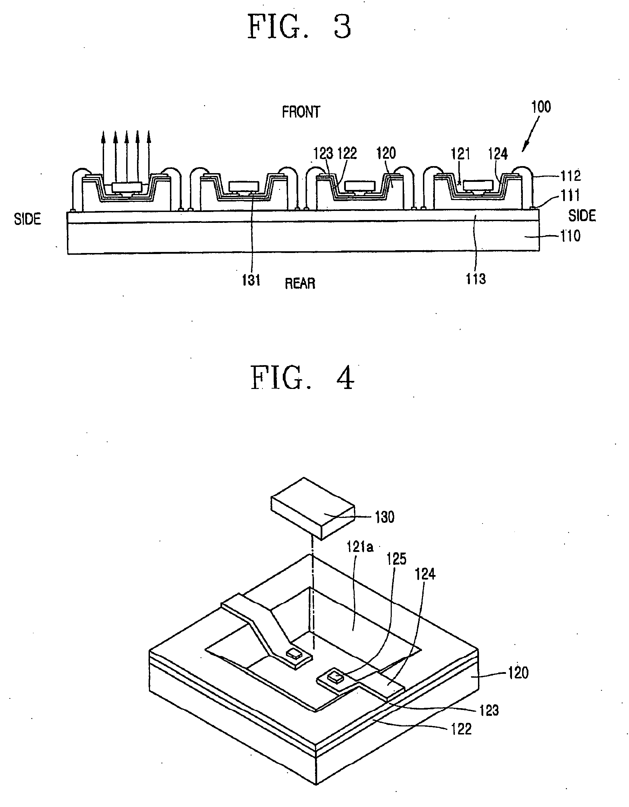

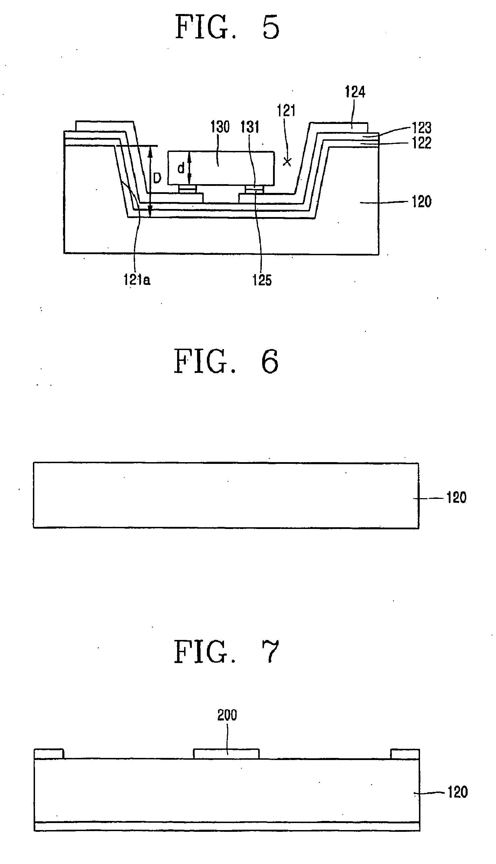

Figure 3 is a longitudinal sectional view showing a light source apparatus in accordance with the present invention, Figure 4 is an exploded perspective view showing a sub-mount and a light emitting device in the light source apparatus in accordance with the present invention, and Figure 5 is a longitudinal sectional view showing the sub-mount and the light emitting device in the light source apparatus in accordance with the present invention.

As shown in Figures 3 to 5, a light source apparatus 100 in accordance with the present invention includes: a metal stem 110; a sub-mount 120 having one surface deposited over the metal stem 110 and the other surface on which a groove 121 is formed, wherein a reflective layer 122, an insulating layer 123, an electrode layer 124 and a solder layer 125 are sequentially deposited over the groove 121; and a light emitting device 130 bonded to the solder layer 125 of the sub-mount 120.

In the light source device 100, by forming the groove 121 at one surface so as to mount the light emitting device 130 thereon, light emitted from the light emitting device 130 does not disperse but is sent to the front side of the metal stem 110, thereby increasing the luminous efficiency. Here, thickness of the sub-mount 120 is reduced by means of the groove 121, thereby facilitating heat generation of the light emitting device 130.

In addition, by forming the reflective layer 122 on the sub-mount 120, light emitted from the front and side surfaces of the light emitting device 130 is effectively collected toward the front of the metal stem 110. Here, the reflective layer 122 is formed by using a deposition method or a lift-off method, and is preferably made of materials such as Ag or Al having a high reflection coefficient.

The insulating layer 123 is formed on an upper surface of the reflective layer 122 in order that the reflective layer 122 does not come in contact with the electrode layer 124.

Any materials having insulating properties are allowable as materials of the insulating layer 123, but one from AIN, ZnO, BeO, SiO₂ and SiNx is preferably used by a sputtering method or a vapor deposition method. In addition, the insulating layer used in a semiconductor process such as a silicon nitride layer can be used.

One of materials which can be bonded with the melting point of less than 400 °C, for example, Au-Sn, In, Pb, Pb-Sn or Ag-Sn is preferably used as the solder layer.

For the reference, in a method for bonding two electrodes, a method for bonding two electrodes by making the two electrodes face each other is called a flip chip bonding method, and a method for connecting the two electrodes by wires is called a normal mounting bonding method. Substantially, electrodes of the light emitting device 130 are divided in to an n-electrode and a p-electrode. However, since the n-electrode and the p-electrode have symmetric connection structures, both the n-electrode and the p-electrode are marked as an electrode 131 for the purpose of simplicity in the present invention.

In case of the light source apparatus 100 in accordance with the present invention, the electrode 131 of the light emitting device 130 is bonded directly to one end of the electrode layer 125 of the sub-mount 120 by the flip chip bonding method, and the other end of the electrode layer 125 of the sub-mount 120 is connected to the electrode layer 111 of the metal stem 110 by the wire 112 by the normal mounting bonding method.

Preferably, the depth (D) of the groove 121 is formed to be greater than the height (d) of the light emitting device 130.

That is, only if the depth (D) of the groove 121 is formed to be greater than the height (d) of the light emitting device 130, light emitted from the side of the light emitting device 130 does not disperse but reflects from the reflective layer 122 and therefore can be collected toward the front of the metal stem 110.

An incline 121 a is formed at the groove 121 in order that light emitted from the side of the light emitting device 130 can be collected toward the front of the metal stem 110, and the reflective layer 122 is deposited along the incline 121 a.

In addition, the light emitting device 130 is typically divided into a laser diode (LD) and a light emitting diode (LED). In Figures 3 to 5, the light emitting device 130 is the light emitting diode (LED).

The insulating layer 113 is deposited over the metal stem 110 and the sub-mount 120 is bonded to the insulating layer 113, whereby the insulating layer 113 insulates the metal stem 110 and the sub-mount 120.

The metal stem 110 is preferably formed of an MC PCB (Metal Core Printed Circuit Board) having superior heat release properties. The MC PCB quickly absorbs heat generated from the light emitting device 130 and emits the heat, thereby making the light emitting device 130 emit light smoothly and extending the life span of the light emitting device 130.

An operation of the light source apparatus having such a construction in accordance with the present invention will be described as follows.

As shown in Figures 3 to 5, when a voltage is applied to the electrode 111 of the metal stem 110, the voltage is applied to the electrode 131 of the light emitting device 130 by the wire 112 and the electrode layer 124.

At this time, holes and electrons injected through the electrode 131 are recombined in an active layer (not shown) of the light emitting device 130. At this time, extra energy is changed into light, which is emitted.

At this time, since the light emitting device 130 is mounted inside the groove 121, light interference between the light emitting devices 130 adjacent to each other can be efficiently prevented.

In addition, the luminous efficiency can be increased because light emitted from the side as well as the front of the light emitting device 130 does not diffuse but is collected toward the front of the metal stem 110 by means of the reflective layer 122.

Meanwhile, Figures 6 to 14 are flowcharts illustrating a fabrication method of the light source apparatus in accordance with the present invention.

As shown in Figures 6 to 14, a fabrication method of the light source apparatus in accordance with the present invention comprises: forming a plurality of grooves 121 at regular intervals on the silicon substrate 120; sequentially forming the electrode layer 124 and the solder layer 125 over a front surface of the silicon substrate 120 at which the grooves are formed 121; forming a plurality of sub-mounts 120 by cutting off the silicon substrate 120 equally by units of groove 121; bonding the light emitting device 130 to the solder layer 125 of the sub-mount 120 such that the electrode 131 of the light emitting device 130 can be connected to the electrode layer 124 of the sub-mount 120; and completing the light source apparatus 100 by aligning the sub-mount 120 with the metal stem 110.

More in detail, as shown in Figures 6 to 8, after a plurality of grooves 121 are formed on a front surface of the silicon substrate 120, the basic material, at regular intervals by using an etching mask 200, the etching mask 200 is removed. At this time, an incline 121a is formed at the side of the groove 121.

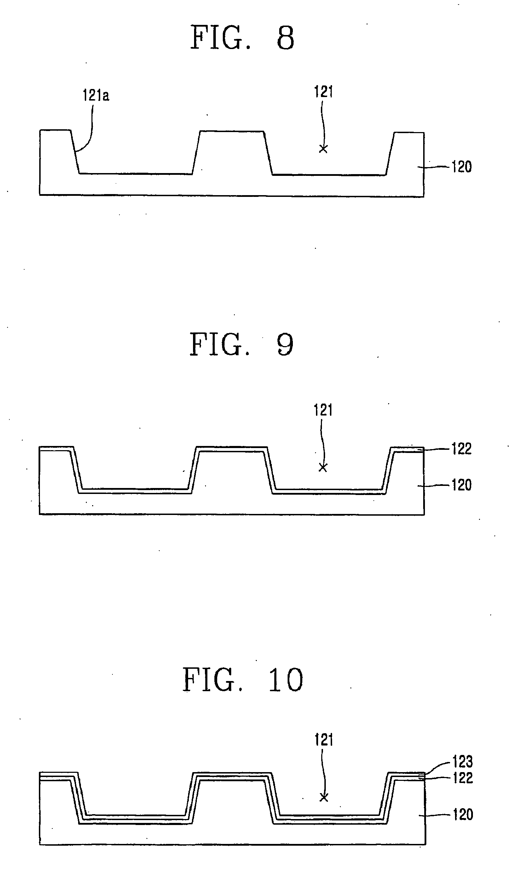

Next, as shown in Figures 9 to 11, the reflective layer 122, the insulating layer 123, the electrode layer 124 and the solder layer 125 are sequentially deposited over a front surface of the silicon substrate 120 on which the grooves 121 are formed. At this time, the electrode layer 124 and the solder layer 125 are preferably formed on part of the insulating layer 123.

Here, the reflective layer 122 is formed by a bonding method or a lift-off method, and is preferably made of materials such as Ag or Al having a high reflection coefficient.

The insulating layer 123 is formed on an upper surface of the reflective layer 122 such that the reflective layer 122 does not come in contact with the electrode layer 124.

AIN, ZnO or BeO having a high heat transfer coefficient is preferably used as materials of the insulating layer 123 by a sputtering method or a vapor deposition method. In addition, an insulating layer used in a semiconductor process such as a silicon nitride layer can be used.

Moreover, the electrode layer 124 is formed on an upper portion of the insulating layer 123 by using a metal etching method or a lift-off method.

Preferably, Au-Sn, In, Pb, Pb-Sn or the like is used as the solder layer 125 so as to insure an electrical connection between the electrode 131 of the light emitting layer 130 and the electrode layer 124.

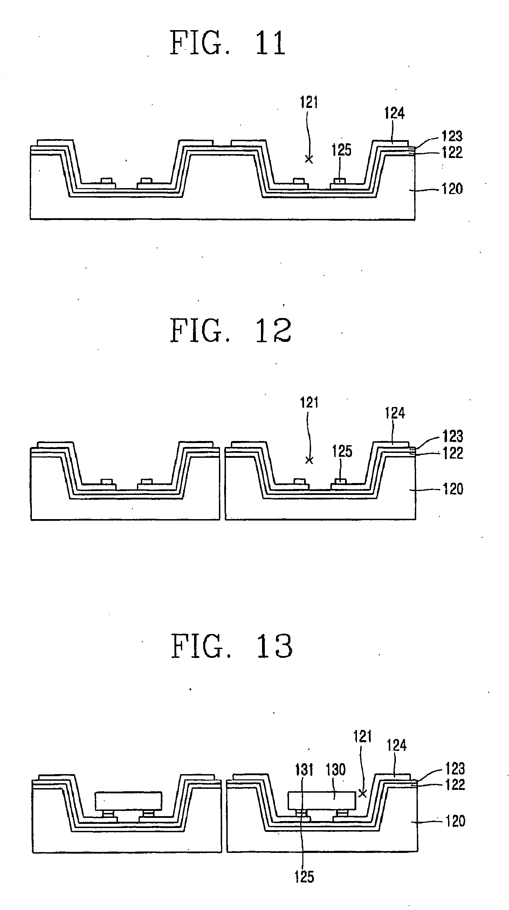

Next, as shown in Figure 12, a plurality of sub-mounts 120 are made in the form of a chip by cutting off the silicon substrate 120 equally by units of groove 121.

Next, as shown in Figure 13, the light emitting device 130 is bonded to the solder layer 125 of the sub-mount 120 by using a flip chip bonding method such that the electrode 131 of the light emitting device 130 is connected with the electrode layer 124 of the sub-mount 120.

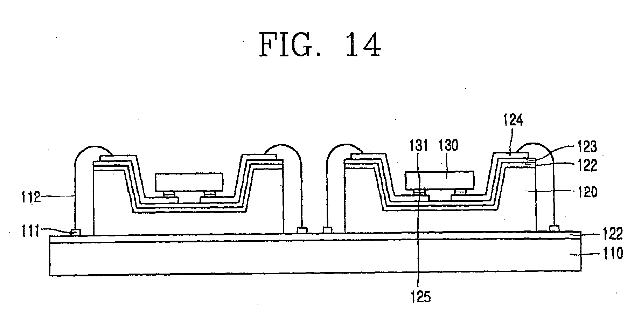

Next, as shown in Figure 14, after the sub-mount 120 is aligned with the metal stem 110, the electrode layer 124 of the sub-mount 120 is connected with the electrode 111 of the metal stem 110 by a normal mounting bonding method, thereby completing the light source apparatus 100.

The completed light source apparatus 100 can be efficiently used in a backlight unit and a camera flash unit.

The fabrication method of the light source apparatus in accordance with the present invention can increase the luminous efficiency when the light source apparatus is applied to the backlight unit, because the incline 121a is formed on the side of the groove 121 and light emitted from the side of the light emitting device 130 is collected toward the front of the metal stem 110 by means of the reflective layer 122 formed along the incline 121 a.

As described so far, according to the present invention, by forming grooves on the front surfaces of sub-mounts and mounting light emitting devices inside the grooves, light interference between the light emitting devices adjacent to each other can be prevented.

In addition, by forming a reflective layer at an inner circumferential surface of the groove, light emitted from the side of the light emitting device can be collected toward the front of the metal stem to thereby increase the luminous efficiency.

Moreover, when the light emitting device is bonded to the solder layer of the sub-mount, the light emitting device is bonded by using a flip chip bonding method, thereby improving the work of the assembly and increasing yield.

As the present invention may be embodied in several forms without departing from the spirit or essential characteristics thereof, it should also be understood that the above-described embodiments are not limited by any of the details of the foregoing description, unless otherwise specified, but rather should be construed within the scope of the appended claims.

## Claims

1. A light source apparatus (100), comprising:
- a sub-mount (120) with one surface having a groove (121), wherein an electrode layer (124) and a solder layer (125) are deposited over the groove (121); and wherein the solder layer (125) is formed on the electrode layer (124);
- a light emitting device (130) bonded to the solder layer (125) of the sub-mount (120),
**characterized by** a metal stem (110), said sub-mount (120) having another surface deposited over the metal stem (110);
- a reflective layer (122) formed on the sub-mount (120) surface having the groove (121); and
- an insulating layer (123) formed on an upper surface of the reflective layer (122),
wherein the electrode layer (124) is formed on an upper portion of the insulating layer (123).

2. The apparatus of claim 1, wherein an electrode (131) of the light emitting device (130) is directly connected with the electrode layer (124) of the sub-mount (120) and the electrode layer (124) of the sub-mount (120) is connected with an electrode layer (111) of the metal stem (110) by a wire.

3. The apparatus of claim 1 or 2, wherein the depth of the groove (121) is formed to be greater than the height of the light emitting device (130).

4. The apparatus of one of the claims 1 to 3, wherein the metal stem (110) is an MC PCB.

5. The apparatus of one of the claims 1 to 4, wherein the light emitting device (130) is an LED.

6. The apparatus of one of the claims 1 to 5, wherein a further insulating layer (113) is deposited over the metal stem (110) and the sub-mount (120) is deposited over the insulating layer (113).

7. The apparatus of one of the claims 1 to 6, wherein an incline is formed at the side of the groove (121) such that light emitted from the side of the light emitting device (130) can be collected toward the front of the metal stem (110).

8. The apparatus of one of the claims 1 to 7, wherein the insulating layer (123) is formed of one of AlN, ZnO, BeO, SiO2 and SiNx.

9. The apparatus of one of the claims 1 to 8, wherein the solder layer (125) is made of a material which can be bonded with the melting point of less than 400 °C.

10. The apparatus of claim 9, wherein the solder layer (125) is formed of one of Au--Sn, In, Pb, Pb--Sn and Ag--Sn.

11. A fabrication method of a light source apparatus (100), comprising:
- forming a plurality of grooves (121) on a silicon substrate (120) at regular intervals, wherein an incline is formed at the side of the groove (121);
- forming a reflective layer (122), an insulating layer (123), an electrode layer (124), and a solder layer (125) sequentially over a front surface of the silicon substrate having the grooves (121), such that the insulating layer (123) is formed on an upper surface of the reflective layer (122);
- forming a plurality of sub-mounts (120) by cutting off the silicon substrate equally by units of groove (121);
- bonding the light emitting device (130) to the solder layer (125) of the sub-mount (120) such that an electrode (131) of the light emitting device (130) can be connected to the electrode layer (124) of the sub-mount (120) by using a flip chip bonding method in the step of bonding the light emitting device (130) to the solder layer (125) of the sub-mount (120);
- completing the light source apparatus (100) by aligning the sub-mount (120) with a metal stem (110), wherein light emitted from the side of the light emitting device (130) is collected toward the front of the metal stem (110) by means of the reflective layer (122) formed along the incline.

12. The method of claim 11, wherein the electrode layer (124) and the solder layer (125) are formed on part of the insulating layer (123).

13. The method of one of the claims 11 or 12, wherein the electrode layer (124) of the sub-mount (120) is connected with an electrode (111) of the metal stem (110) by a general mounting bonding method.

14. The method of one of the claims 11 to 13, wherein the light emitting device (130) is used in a backlight unit and a camera flash unit.

## Patentansprüche

1. Lichtquellenvorrichtung (100), aufweisend:
- einen Unterbau (120) mit einer Oberfläche mit einer Vertiefung (121), in welcher eine Elektrodenschicht (124) und ein Lötschicht (125) über der Vertiefung (121) aufgebracht sind, und in welcher die Lötschicht (125) auf der Elektrodenschicht (124) ausgebildet ist;
- eine lichtemittierende Vorrichtung (130), welcher mit der Lötschicht (125) des Unterbaus (120) verbunden ist,
**gekennzeichnet durch** einen Metallkörper (110), wobei der Unterbau (120) eine andere Oberfläche hat, welche über dem Metallkörper (110) aufgebracht ist;
- eine reflektierende Schicht (122), welche auf der Unterbau (120)-Oberfläche mit der Vertiefung (121) gebildet ist, und
- eine Isolierschicht (123), welche auf einer oberen Oberfläche der reflektierenden Schicht (122) gebildet ist,
wobei die Elektrodenschicht (124) auf einem oberen Teil der Isolierschicht (123) gebildet ist.

2. Vorrichtung nach Anspruch 1, wobei eine Elektrode (131) der lichtemittierenden Vorrichtung (130) direkt mit der Elektrodenschicht (124) des Unterbaus (120) verbunden ist, und die Elektrodenschicht (124) des Unterbaus (120) mit einer Elektrodenschicht (111) des Metallkörpers (110) durch einen Draht verbunden ist.

3. Vorrichtung nach Anspruch 1 oder 2, wobei die Tiefe der Vertiefung (121) so ausgebildet ist, dass sie größer ist als die Höhe der lichtemittierenden Vorrichtung (130).

4. Vorrichtung nach einem der Ansprüche 1 bis 3, wobei der Metallkörper (110) eine Metallkern-Leiterplatte ist.

5. Vorrichtung nach einem der Ansprüche 1 bis 4, wobei die lichtemittierende Vorrichtung (130) eine LED ist.

6. Vorrichtung nach einem der Ansprüche 1 bis 5, wobei eine weitere Isolierschicht (113) über dem Metallkörper (110) aufgebracht ist, und der Unterbau (120) über der Isolierschicht (113) aufgebracht ist.

7. Vorrichtung nach einem der Ansprüche 1 bis 6, wobei eine Neigung an der Seite der Vertiefung (121) so gebildet ist, dass Licht, welches von der Seite der lichtemittierenden Vorrichtung (130) emittiert wird, zur Vorderseite des Metallkörpers (110) hin gesammelt werden kann.

8. Vorrichtung nach einem der Ansprüche 1 bis 7, wobei die Isolierschicht (123) aus einem der AlN, ZnO, BeO, SiO2 und SiNx gebildet ist.

9. Vorrichtung nach einem der Ansprüche 1 bis 8, wobei die Lötschicht (125) aus einem Material hergestellt ist, welches mit dem Schmelzpunkt von weniger als 400°C verbunden werden kann.

10. Vorrichtung nach Anspruch 9, wobei die Lötschicht (125) aus einem der Au-Sn, In, Pb, Pb-Sn und Ag-Sn gebildet ist.

11. Herstellungsverfahren einer Lichtquellenvorrichtung (100), aufweisend:
- Bilden eine Vielzahl von Vertiefungen (121) auf einem Siliciumsubstrat (120) in regelmäßigen Intervallen, wobei an der Seite der Vertiefung (121) eine Neigung ausgebildet ist;
- Bilden einer reflektierenden Schicht (122), einer Isolierschicht (123), einer Elektrodenschicht (124) und einer Lötschicht (125) nacheinander über einer Vorderfläche des Siliciumsubstrats mit den Vertiefungen (121), so dass die Isolierschicht (123) auf einer oberen Fläche der reflektierenden Schicht (122) gebildet ist;
- Bilden einer Vielzahl von Unterbauen (120) durch gleichmäßiges Abschneiden des Siliciumsubstrats in Vertiefungs (121)-Einheiten;
- Verbinden der lichtemittierenden Vorrichtung (130) mit der Lötschicht (125) des Unterbaus (120), so dass eine Elektrode (131) der lichtemittierenden Vorrichtung (130) mit der Elektrodenschicht (124) des Unterbaus (120) verbunden werden kann unter Verwendung eines Flip-Chip-Bonding-Verfahrens beim Schritt des Verbindens der lichtemittierenden Vorrichtung (130) mit der Lötschicht (125) des Unterbaus (120);
- Vervollständigen der Lichtquellenvorrichtung (100) durch Ausrichten des Unterbaus (120) mit einem Metallkörper (110), wobei Licht, welches von der Seite der lichtemittierenden Vorrichtung (130) austritt, zur Vorderseite des Metallkörpers (110) hin gesammelt wird mittels der reflektierenden Schicht (122), welche längs der Neigung gebildet ist.

12. Verfahren nach Anspruch 11, wobei die Elektrodenschicht (124) und die Lötschicht (125) zum Teil auf der Isolierschicht (123) gebildet sind.

13. Verfahren nach einem der Ansprüche 11 oder 12, wobei die Elektrodenschicht (124) des Unterbaus (120) mit einer Elektrode (111) des Metallkörpers (110) durch ein allgemeines Montageverbindungsverfahren verbunden wird.

14. Verfahren nach einem der Ansprüche 11 bis 13, wobei die lichtemittierende Vorrichtung (130) in einer Hintergrundbeleuchtungseinheit und einer Kamerablitzlichteinheit verwendet wird.

## Revendications

1. Appareil formant source de lumière (100), comprenant :
- une monture annexe (120) avec une surface ayant une gorge (121), dans lequel une couche électrode (124) et une couche de soudure (125) sont déposées par-dessus la gorge (121), et dans lequel la couche de soudure (125) est formée sur la couche électrode (124);
- un dispositif émetteur de lumière (130) collé sur la couche de soudure (125) de la monture annexe (120),
**caractérisé par** une tige de métal (110), ladite monture annexe (120) ayant une autre surface déposée par-dessus la tige de métal (110),
- une couche réflectrice (122) formée sur la surface de la monture annexe (120) ayant la gorge (121) ; et
- une couche isolante (123) formée sur une surface supérieure de la couche réflectrice (122),
dans lequel la couche électrode (124) est formée sur une portion supérieure de la couche isolante (123).

2. Appareil selon la revendication 1, dans lequel une électrode (131) du dispositif émetteur de lumière (130) est directement connectée avec la couche électrode (124) de la monture annexe (120) et la couche électrode (124) de la monture annexe (120) est connectée avec une couche électrode (111) de la tige de métal (110) par un fil.

3. Appareil selon la revendication 1 ou 2, dans lequel la profondeur de la gorge (121) est formée pour être plus grande que la hauteur du dispositif émetteur de lumière (130).

4. Appareil selon l'une des revendications 1 à 3, dans lequel la tige de métal (110) est une carte à circuits imprimés dite "MC PCB".

5. Appareil selon l'une des revendications 1 à 4, dans lequel le dispositif émetteur de lumière (130) est une diode électroluminescente.

6. Appareil selon l'une des revendications 1 à 5, dans lequel une autre couche isolante (113) est déposée par-dessus la tige de métal (110), et la monture annexe (120) est déposée par-dessus la couche isolante (113).

7. Appareil selon l'une des revendications 1 à 6, dans lequel une partie inclinée est formée sur le côté de la gorge (121) de telle sorte que la lumière émise depuis le côté du dispositif émetteur de lumière (130) peut être collectée vers la partie frontale de la tige de métal (110).

8. Appareil selon l'une des revendications 1 à 7, dans lequel la couche isolante (123) est formée de l'un des matériaux AlN, ZnO, BeO, Si02 et SiNx.

9. Appareil selon l'une des revendications 1 à 8, dans lequel la couche de soudure (125) est faite d'un matériau qui peut être collé avec un point de fusion inférieur à 400° C.

10. Appareil selon la revendication 9, dans lequel la couche de soudure (125) est formée de l'un des matériaux Au--Sn, In, Pb, Pb--Sn et Ag--Sn.

11. Procédé de fabrication d'un appareil formant source de lumière (100), comprenant les étapes consistant à :
- former une pluralité de gorges (121) sur un substrat en silicium (120) à intervalles réguliers, de sorte qu'une partie inclinée est formée sur le côté de la gorge (121) ;
- former une couche réflectrice (122), une couche isolante (123), une couche électrode (124), et une couche de soudure (125) en séquence sur une surface frontale du substrat en silicium ayant les gorges (121), de telle façon que la couche isolante (123) est formée sur une surface supérieure de la couche réflectrice (122) ;
- former une pluralité de montures annexes (120) en découpant le substrat en silicium de manière égale par unités de gorge (121) ;
- coller le dispositif émetteur de lumière (130) sur la couche de soudure (125) de la monture annexe (120) de telle façon qu'une électrode (131) du dispositif émetteur de lumière (130) peut être connectée à la couche électrode (124) de la monture annexe (120) en utilisant un procédé de collage dit "flip chip" dans l'étape consistant à coller le dispositif émetteur de lumière (130) sur la couche de soudure (125) de la monture annexe (120);
- terminer l'appareil formant source de lumière (100) en alignant la monture annexe (120) avec une tige de métal (110), de sorte que la lumière émise depuis le côté du dispositif émetteur de lumière (130) est collectée vers la partie frontale de la tige de métal (110) au moyen de la couche réflectrice (122) formée le long de la partie inclinée.

12. Procédé selon la revendication 11, dans lequel la couche électrode (124) et la couche de soudure (125) sont formées sur une partie de la couche isolante (123).

13. Procédé selon l'une des revendications 11 ou 12, dans lequel la couche électrode (124) de la monture annexe (120) est connectée avec une électrode (111) de la tige de métal (110) par un procédé de collage et de montage général.

14. Procédé selon l'une des revendications 11 à 13, dans lequel le dispositif émetteur de lumière (130) est utilisé dans une unité de rétroéclairage et dans une unité de flash pour caméra.
